# EUROPEAN PATENT APPLICATION

(11) **EP 1 809 085 A1**
(43) Date of publication of application: **18.07.2007**
(21) Application number: 06100414.9
(22) Date of filing: 16.01.2006
(51) Int. Cl.: H05K 7/10

(54) **VGA interface card**

(71) Applicant: Lih Duo International Co., Ltd., Wu Gu Shiang, Taipei Hsien (TW)
(72) Inventor: Wang, Sung-Lai, Wu Gu Shiang, Taipei Hsien (TW)
(74) Representative: Beck, Michael Rudolf

(57) **Abstract**

A VGA interface card (20) comprises a base plate (21) with a GPU (23) and one or more IC embedding seats (30) formed thereon to have IC memory chip being installed in detachable manner which provides the advantage of easy installation, convenient maintenance or replacement of IC memory chip, particularly no longer using SMT and soldering paste or flux for IC maintenance and replacement; the IC embedding seat (30) used on the VGA interface card (20) comprises a mainbody (40) having one or more IC mounting compartments (41) and a sliding cover (50) formed a cover to the mainbody (40) with sliding movement to open or close the mainbody (40), and each IC mounting compartment (41) of the mainbody (40) has a plurality of conducting pin units (44) arrayed in matrix arrangement to form electric connection with the base plate (21); during IC maintenance and replacement, any defective IC memory chip shall be freely removed from the VGA interface card (20) without de-soldering to prevent other good IC memory chip from damage due to high temperature.

## Description

### BACKGROUND OF THE INVENTION

### 1. Field of the Invention

The invention relates to a Video Graphic Array interface card, particularly the Video Graphic Array interface card provides IC memory chips being installed in detachable manner.

### 2. Description of the Prior Art

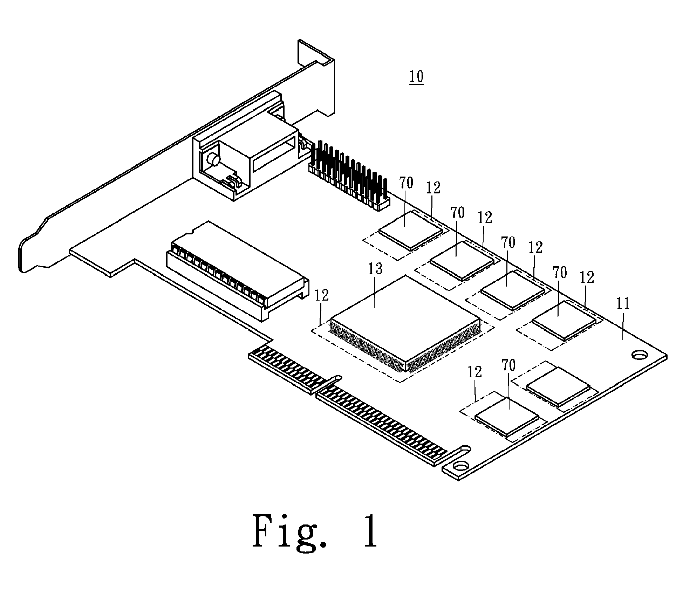

The conventional Video Graphic Array interface card 10 (hereinafter abbreviated as VGA interface card 10) for displaying images normally has a structure shown in Fig. 1 which is formed by fixedly installing a Graphic Processing Unit (GPU) 13 and plural IC memory chips 70 on a printed circuit board (PCB) 11 by soldering. Wherein the PCB 11 used for the VGA interface card 10 has a plurality of printed circuit sets 12 used for processing graphic information thereon, each printed circuit set 12 is designed by soldering to form an electric connection with the corresponding GPU 13 and the corresponding IC memory chip 12 respectively. Therefore, when the VGA interface card 10 is used to a personal computer, it provides with the function of operating the graphic data transmitted from CPU of the computer and outputting the processed graphic data from the GPU 13 to display images including text data and graphic data onto the screen of a monitor.

The IC memory chip(s) 70 installed on the VGA interface card 10 is used to temporarily memory the graphic data processed and transmitted from the GPU 13, so that the performance of VGA interface card 10 is decided from what grade of IC memory chip 70 used on the VGA interface card 10. If the speeds of IC memory chip 70 to access graphic data transmitted from the GPU 13 is much faster or the memory capacity to memory data of the IC memory chip 70 is much larger, the VGA interface card 10 shall have high performance to process graphic data.

In the VGA interface card 10, the IC memory chip 70 is one of the major elements, and the packing method of the IC memory chip 70 has been gradually improved to involve from the Thin Small Outline Package (TSOP) method to the Ball Grid Array (BGA) method.

If the mentioned VGA interface card 10 has improved to use the kind of IC memory chip 70 with Ball Grid Array package carrying Tin balls on bottom, hereinafter being called IC memory chip 70, it shall be installed on PCB 11 of the VGA interface card 10 by employing Surface Mount Technology (SMT) to join the Tin balls arranged on bottom of the IC memory chip 70 securely connected to its corresponding printed circuit set 12 on the PCB 11 by soldering.

However, due to the IC memory chip 70 fixed on the PCB 11 of VGA interface card 10 through Tin balls and soldering, it will cause the VGA interface card 10 while in use could not further increase IC memory chip 70 any more, and if removal of an IC memory chip 70 from the VGA interface card 10 is necessary a de-soldering process with high temperature should be proceeded, so that the VGA interface card 10 is so inconvenient in replacement and maintenance of IC memory chip 70.

Therefore, when a user wants to upgrade a VGA interface card 10 already in use, the only way to the user is to pick out and buy an advanced VGA interface card 10 again, it is impossible by way of increasing quantity of IC memory chip 70 or replacing a new IC memory chip 70 with enlarged memory capacity to upgrade the originally used VGA interface card 10.

Further, when the IC memory chip 70 with Ball Grid Array package is for repair to be removed from the VGA interface card 10, in addition to the removal of original Tin balls by de-soldering with high temperature, new Tin balls must be re-embedded to the IC memory chip 70 and the repaired IC memory chip 70 must be re-positioned and re-soldered to the PCB 11 of the VGA interface card 10 again. However, there are some difficulties on re-embedding the Tin balls and re-positioning the repaired IC memory chip 70.

Especially, during removal of Tin balls from an IC memory chip 70 by high temperature, the undamaged IC memory chips 70 of the VGA interface card 10 are likely to be damaged due to high temperature, and, the removed Tin balls and the soldering paste as well as flux used during re-embedding process all will cause environmental pollution problem that is detrimental to the environment.

### SUMMARY OF THE INVENTION

In order to overcome the conventional VGA interface card having drawbacks of inconvenience in maintenance and replacement of IC memory chip, the present invention is disclosed a novel VGA interface card which allows installation of IC memory chip on the invented VGA interface card in detachable manner particularly without the needs of soldering past and flux, and the invented VGA interface card of the invention possesses specific advantageous features of easy installation, convenient maintenance or convenient replacement of IC memory chip and better protection of environment.

The structure of VGA interface card of the invention comprises a base plate, on which surface at least has been formed a Graphic Processing Unit (GPU), a plurality of printed circuit sets with function of processing graphic information, and one or more IC embedding seats each being in electrical connection with a corresponding printed circuit set on the base plate. The IC embedding seat on the base plate comprises a mainbody and a sliding cover, which are assembled to form a sliding mechanism with relative sliding movement so that the mainbody can be opened and closed by the sliding cover by sliding method, and the mainbody has one or more IC mounting compartment for mounting IC memory chip in detachable manner, i.e., the IC memory chip can be easily mounted into or freely removed from the mounting compartment which is also provided with the effect of positioning the embedded IC memory chip.

Arranged on the bottom of each IC mounting compartment of the mainbody of IC embedding seat is a conducting pin array which is formed by a plurality of conducting pin unit with elasticity and conductivity and arranged in matrix arrangement. Therefore, the electrical connection between the IC memory chip and the corresponding printed circuit set on base plate can be achieved by means of the conducting pin array formed on the mainbody of the IC embedding seat.

When IC memory chip with Ball Grid Array package is embedded into IC mounting compartment of an IC embedding seat installed on VGA interface card of the invention, an electrical connection between the IC memory chip and the conducting pin array on the mainbody of the IC embedding seat can be achieved which, in turn, can further achieve the electrical connection between the IC memory chip and the base plate of VGA interface card of the invention, and enable the installation of IC memory chip on the VGA interface card of the invention in detachable manner.

Therefore, when it needs to do maintenance or to replace IC memory chip from the VGA interface card of the invention, the work can be carried out simply by removing the damaged memory chip and replacing it with a new one without high temperature de-soldering and without using Tin balls, soldering paste and flux entirely, or when it needs to upgrade the IC memory chip to enlarge memory capacity to the VGA interface card of the invention, the user can easily replace IC memory chip with an advanced IC memory chip having larger memory capacity. These advantageous features derived from the VGA interface card of the invention can be concluded as follows:
1. Replacing IC memory chip from the VGA interface card or upgrading IC memory chip to enlarge memory capacity to the VGA interface card can be easily done by the user itself.
2. Much easier and simpler to carry out maintenance and replacement of IC memory chip from the VGA interface card.
3. Reduce the bothering cost and work for re-implanting Tin balls to a repaired IC memory chip used on VGA interface card.
4. Replacement and maintenance of IC memory chip(s) used on VGA interface card can be carried out at any time without the problem of specialized positioning.
5. Avoid IC memory chip used on VGA interface card getting damaged from high soldering temperature.
6. Without use of soldering paste and flux to achieve a better effect in environmental protection.

### BRIEF DESCRIPTION OF THE DRAWINGS

Fig. 1 is a schematic drawing of the structure of conventional VGA interface card.
Fig. 2 is a schematic drawing of a VGA interface card of the invention showing that IC memory chip is installed on the VGA interface card in detachable manner.
Fig. 3 is an enlarged drawing of the embodiment of the IC embedding seat shown in Fig. 2.
Fig. 4 is an enlarged sectional view along line 4-4 of Fig. 2 showing that the IC embedding seat of the VGA interface card of the invention has the effect of positioning the IC memory chip which carries Tin balls on underside.
Fig. 5 is a disassembly drawing of the VGA interface card of the invention showing the IC embedding seat uses an auxiliary positioning frame to achieve the application for positioning a plane IC memory chip with flat surface on underside.
Fig. 6 is an enlarged sectional view along line 6-6 of Fig. 5 showing an IC embedding seat of the present invention using an auxiliary positioning frame to position a plane IC memory chip with flat surface on underside.
Fig. 7 is a schematic drawing showing the structure of the IC embedding seat of the VGA interface card of the invention in which the mainbody of the IC embedding seat may have one more than one IC mounting compartment.

### DESCRIPTION OF THE PREFERRED EMBODIMENT

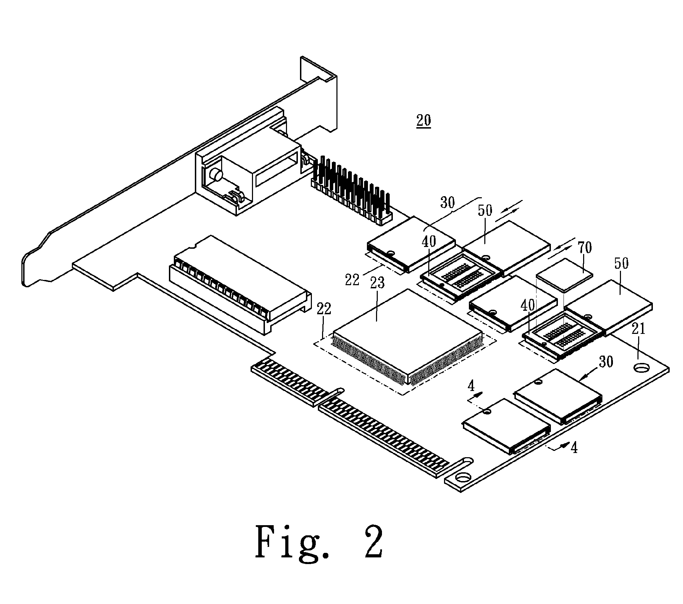

As illustrated in Fig. 2, the VGA interface card 20 of the invention is structured to allow the IC memory chip 70 to be installed on the VGA interface card 20 in detachable manner.

The structure of VGA interface card 20 of the invention comprises a base plate 21 formed with a plurality of printed circuit sets 22 having function of processing graphic information, a Graphic Processing Unit (GPU) 23 installed on the base plate 21 and formed an electric connection with a corresponding printed circuit set 22 of the base plate 21, and one or more IC embedding seats 30 installed on one side or both sides of the base plate 21 and each formed an electric connection with a corresponding printed circuit set 22 of the base plate 21 to enable the effect of easy installation and easy removal of the IC memory chip 70 on and from the VGA interface card 20.

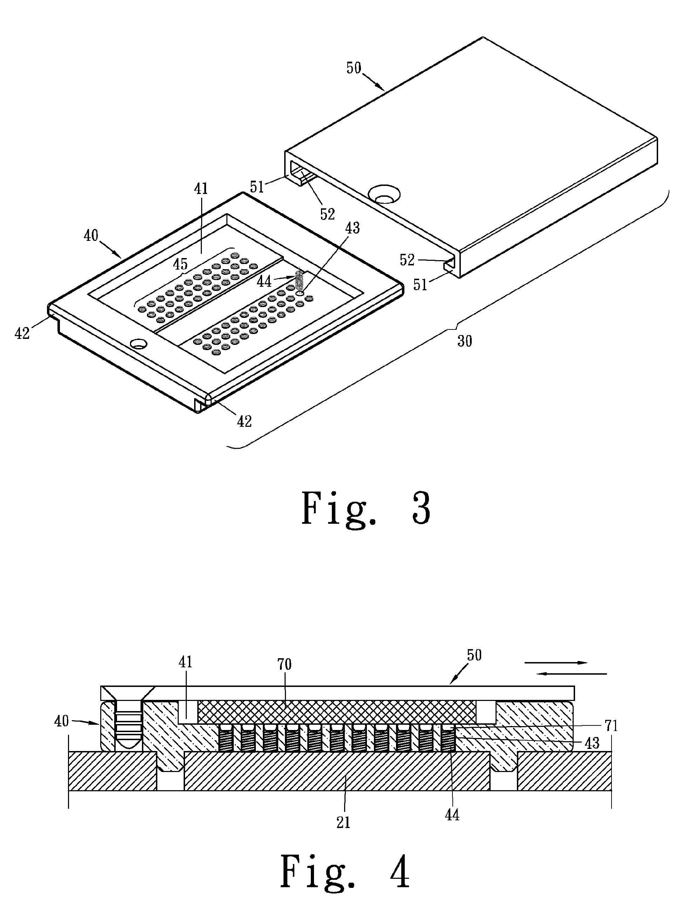

As shown in Figs. 2 and 3, each IC embedding seat 30 installed on the base plate 21 comprises a mainbody 40 and a sliding cover 50 both jointly assembled as a sliding mechanism with the sliding cover 50 able to open or close the mainbody 40 by way of generating a sliding movement corresponding to the mainbody 40. Therefore, by sliding movement of the sliding cover 50, the mainbody 40 has a function similar to a cabinet. It can provide an assembly method for the IC memory chip 70 to be embedded into or dismounted from the mainbody 40 freely.

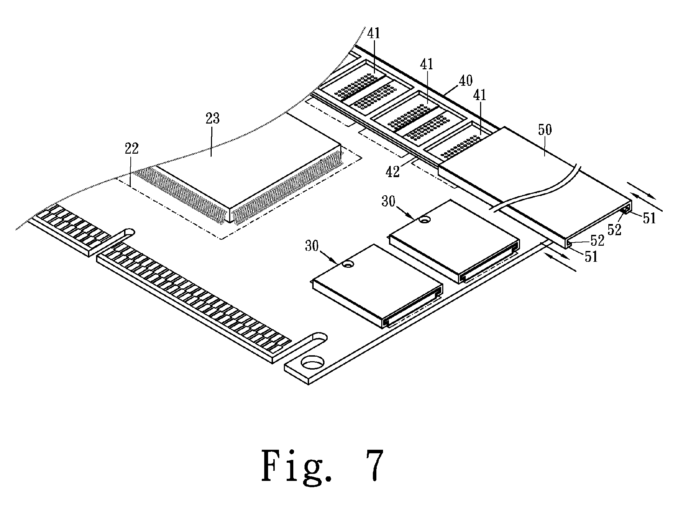

As shown in Figs. 3 or 7, the structure of the mainbody 40 comprises one or more IC mounting compartments 41 and two opposite sliding blocks 42 formed on and extended from both sides of the mainbody 40. In particular, on its bottom of each IC mounting compartment 41 of the mainbody 40 has a plurality of positioning holes 43 formed and arranged in matrix arrangement, and each positioning hole 43 has a conducting pin unit 44 with elasticity and conductivity to form a conducting pin array 45 on the bottom of each IC mounting compartment 41 of the mainbody 40. The embodiment of the conducting pin unit 44 may be a metal spring, or an elastic probe pin or a metal dome; however the preferred embodiment is the one using metal spring.

The structure of the sliding cover 50 is shaped by having its two edges bent downwardly to form a bent portions 51 which also forms a sliding slots 52 on both sides opposite to each other and fitted to the corresponding sliding block 42 of the mainbody 40 to construct a sliding mechanism. And, the sliding cover 50 forms the cover of the mainbody 40 to provide means for opening or closing the mainbody 40 by sliding movement.

As depicted in Figs. 2 and 4, after all the IC embedding seats 30 of the VGA interface card 20 are installed on the base plate 21, each IC embedding seat 30 is therefore electrically connected to its corresponding printed circuit set 22 on the base plate 21 through the conducting pin array 45 formed in the IC mounting compartments 41 of the mainbody 40.

Moreover, only by moving the sliding cover 50 of the IC embedding seat 30, the mainbody 40 of the IC embedding seat 30 can be opened for installing the IC memory chip 70, which is packed with Ball Grid Array package carrying Tin balls 71 on the underside as shown in Fig. 4, into the IC embedding seat 30 of the VGA interface card 20 of the invention in detachable manner.

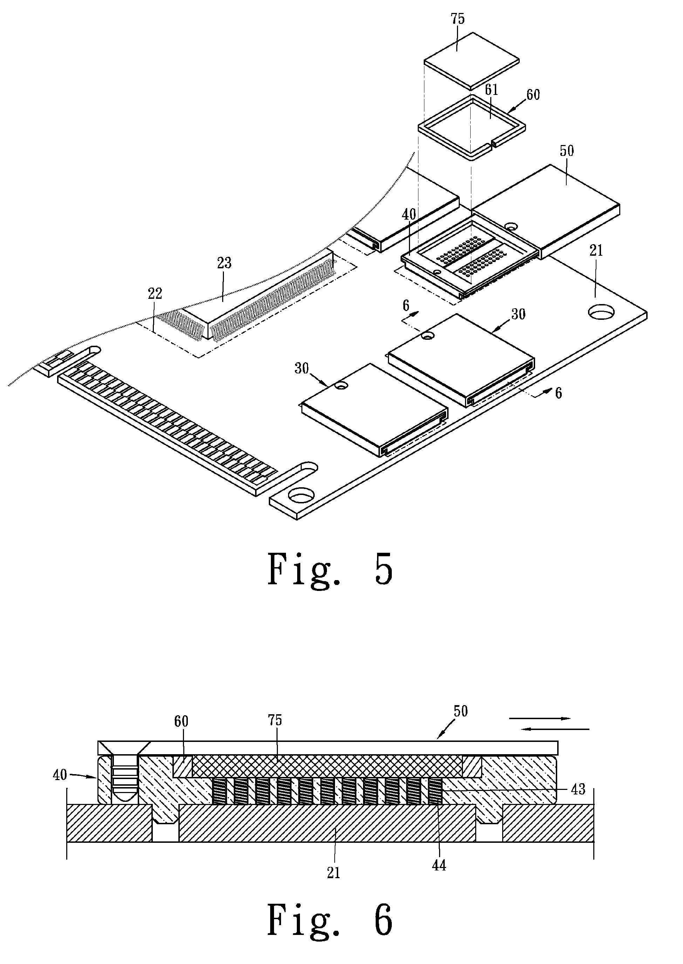

In addition, the VGA interface card 20 of the invention is also to provide an assembly method for another kind of IC memory chip with non-BGA package having conductive contacts on the flat underside (hereinafter being called plane IC memory chip 75 as shown in Fig. 6) to easily and freely embed into the IC embedding seat 30 of the VGA interface card 20 in detachable manner.

Further, as shown in Figs. 4 or 6, after the IC memory chip 70 or the plane IC memory chip 75 is correspondingly embedded into the mainbody 40 of a corresponding IC embedding seat 30 installed on the VGA interface card 20 of the invention, the Tin balls 71 on the underside of the IC memory chip 70 (or the conductive contacts on the underside of the plane IC memory chip 75) will touch and press the conducting pin array 45 in the IC mounting compartment 41 of the mainbody 40, and then move the sliding cover 50 in sliding manner to close the mainbody 40 of the IC embedding seat 30 to prevent the IC memory chip 70 (or the plane IC memory chip 75) already embedded in the IC embedding seat 30 from movement, and to enable a tight contact between Tin balls 71 on the underside of the IC memory chip 70 (or the conductive contacts on the underside of the IC memory chip 75) and the corresponding conducting pin units 44 inside the mainbody 40 of the IC embedding seat 30 to form a good electric connection.

In other wards, when the IC memory chip 70 (or the plane IC memory chip 75) is embedded into the corresponding mainbody 40 of the IC embedding seat 30 of the VGA interface card 20 of the invention, it needs not to use Surface Mounting Technique (SMT) or any soldering paste and flux to form electric connection.

Simply by moving the sliding cover 50 to close the mainbody 40 of the IC embedding seat 30, an electric connection between the embedded IC memory chip 70 (or the embedded plane IC memory chip 75) and the corresponding printed circuit set 22 on the base plate 21 of the VGA interface card 20 can be achieved.

Therefore, by employing the installation manner as described above, the VGA interface card 20 of the invention can achieve the purpose of allowing installation of IC memory chip 70 or the plane IC chip 75 in detachable manner.

Similarly, when the IC memory chip 70 or the plane IC memory chip 75 already installed in the VGA interface card 20 of the invention is to be removed, the only thing needed to do is in sliding manner to move the sliding cover 50 to open the mainbody 40 of the IC embedding seat 30, and then freely remove the IC memory chip 70 or the plane IC memory chip 75 from the mainbody 40 of the IC embedding seat 30 without needs of high temperature de-soldering procedure.

Therefore, when any defective IC memory chip 70 or plane IC memory chip 75 needed to be repaired or replaced is found in the VGA interface card 20 of the invention, the repair or replacement work can be simply done by removing the defective IC memory chip 70 or plane IC memory chip 75 from the mainbody 40 of the IC embedding seat 30, and then installing a new IC memory chip 70 or plane IC memory chip 75 into the corresponding mainbody 40, i.e., the repair or replacement work is so convenient and simple that it does not need to process de-soldering with high temperature and can prevent other good IC memory chip 70 or plane IC memory chip 75 from damage due to high temperature, and it does not require using SMT, soldering paste, or flux for IC maintenance and replacement and can eliminate the bothering due to re-embedding the Tin balls on IC memory chip 70 and repositioning the IC memory chip 70.

Further, when the needs of upgrading the VGA interface card 20 and enlarging memory capacity of the IC memory chip 70 or the plane IC memory chip 75 is required by user, the VGA interface card 20 of the invention provides an advantageous feature of being reusable. Simply by removing the IC memory chip 70 or the plane IC memory chip 75 from the embedding seat 30 of the VGA interface card 20 of the invention, and then reinstalling new IC memory chip 70 or plane IC memory chip 75 having larger memory capacity therein, the upgrading of VGA interface card 20 of the invention can be achieved, particularly, the upgrading work can be carried out by the user without any problem.

In addition, the IC embedding seat 30 used on the VGA interface card 20 of the invention also possesses an effect of positioning the IC memory chip 70 or the plane IC memory chip 75. As illustrated in Figs. 4 and 6, the VGA interface card 20 of the invention is structured in such a way that the positioning holes 43 formed in each IC mounting compartment 41 of mainbody 40 of IC embedding seat 30 are arranged into matrix form to fit the position of corresponding Tin balls 71 on the underside of the IC memory chip 70, or to match the position of corresponding the conductive contacts on the underside of the plane IC memory chip 75.

As illustrated in Fig. 4, when the IC memory chip 70 carrying Tin balls 71 is embedded into the IC mounting compartment 41 of the mainbody 40 of the IC embedding seat 30, the Tin balls 71 of the IC memory chip 70 can embedded into the positioning holes 43 of the mainbody 40 to achieve an effect of positioning the IC memory chip 70.

And, as illustrated in Figs. 5 and 6, when the plane memory chip 75 carrying the conductive contacts on the underside is embedded into the IC mounting compartment 41 on the mainbody 40 of the IC embedding seat 30, an auxiliary positioning frame 60 can be employed to achieve an effect of positioning.

The auxiliary positioning frame 60 has a hollow inner space 61 formed to tightly hold the plane IC memory chip 75, and outer circumference of the auxiliary positioning frame 60 is intentionally designed to tightly fit the inner circumference of the IC mounting compartment 41 of the mainbody 40 of the IC embedding seat 30 to allow the plane IC memory chip 75 to be tightly embedded into the IC mounting compartment 41 of the mainbody 40.

Therefore, when mounting the plane IC memory chip 75 into IC mounting compartment 41 of the mainbody 40, the plane IC memory chip 75 is tightly embedded into the hollow inner space 61 of the auxiliary positioning frame 60 at first, and then the auxiliary positioning frame 60 accompanied with the plane IC memory chip 75 inside is tightly embedded into the IC mounting compartment 41 to achieve an effect of positioning the plane IC memory chip 75 in the IC mounting compartment 41 of the mainbody 40 of IC embedding seat 30 installed on the VGA interface card 20 of the invention.

Another embodiment of the VGA interface card 20 of the invention has an alternative design to the structure of the IC embedding seat 30 in which the mainbody 40 of the IC embedding seat 30 has sliding slots on both sides, and the sliding cover 50 of the IC embedding seat 30 has sliding blocks arranged to fit the sliding slot of the mainbody 40 and to have the mainbody 40 and the sliding cover 50 jointly formed a sliding mechanism.

As concluded above, the VGA interface card 20 of the invention by employing the invented IC embedding seat 30 installed on the base plate 21 can provide a specific function of installing IC memory chip 70 or plane IC memory chip 75 on the VGA interface card 20 in detachable manner, and particularly the IC memory chip 70 or the plane IC memory chip 75 can be easily removed and replaced at any time that enables the VGA interface card 20 of the invention provides the specific features of simple installation, convenient maintenance or replacement of IC memory chip 70 or plane IC memory 75.

## Claims

1. A VGA interface card provided IC memory chip being installed in detachable manner **characterized in that** the VGA interface card (20) comprises:
a base plate (21) formed with a plurality of printed circuit sets (22) having function of processing graphic information;
a Graphic Processing Unit (23) installed on the base plate (21) and formed electric connection with a corresponding printed circuit set (22) of the base plate (21); and
one or more IC embedding seats (30) formed on one side or both sides of the base plate (21) and each formed electric connection with its corresponding printed circuit set (22) of the base plate (21) respectively, wherein each IC embedding seat (30) comprises a mainbody (40) having one or more IC mounting compartments (41) for IC memory chip embedded thereinto and a sliding cover (50) formed a cover to the mainbody (40) with sliding movement to open or close the mainbody (40), and each IC mounting compartment (41) of the mainbody (40) has a conducting pin array (45) formed by a plurality of conducting pin units (44) with elasticity and conductivity arrayed in matrix arrangement to form electric connection with the corresponding printed circuit set (22) of the base plate (21).

2. The VGA interface card as described in claim 1, wherein the conducting pin unit (44) is a metal spring, a metal dome or a probe pin.

3. The VGA interface card as described in claim 1, wherein the mainbody (40) has two sliding blocks (42) formed on both sides and extended in outward direction, and the sliding cover (50) has two sliding slots (52) formed on its both sides to correspondingly fit the sliding blocks (42) of the mainbody (40).

4. The VGA interface card as described in claim 1, wherein the mainbody (40) has two sliding slots formed on both sides and the sliding cover (50) has two sliding blocks formed on both sides to correspondingly fit the two sliding slots of the mainbody (40).

5. The VGA interface card as described in claim 1, 2, 3 or 4, wherein the IC embedding seat (30) further includes an auxiliary positioning frame (60) which has a hollow inner space (61) for IC memory chip tightly embedded therein and has an outer circumference able to tightly fit into the IC mounting compartment (41) of the mainbody (40).
